# EUROPEAN PATENT APPLICATION

(11) **EP 2 876 185 A1**
(43) Date of publication of application: **27.05.2015**
(21) Application number: 13193897.9
(22) Date of filing: 21.11.2013
(51) Int. Cl.: C23C 16/04, C23C 16/06, C23C 4/08, C23C 4/02, F01D 5/28, C23C 10/04, C23C 10/48

(54) **Coated article and method of applying a coating to an article**

(71) Applicant: Siemens Aktiengesellschaft, 80333 München (DE)
(72) Inventor: Bluck, Richard, Welton, Lincoln, LN2 3FQ (GB); Butler, David, Nottingham, NG2 7BL (GB); Marchant, Geoffrey, Lincoln, LN6 9SY (GB); Padley, Paul, Tattershall, Lincoln, LN4 4HB (GB)
(74) Representative: Maier, Daniel Oliver

(57) **Abstract**

1. An article (1) for use in a hot and corrosive medium, where at least a section of an external surface of the article (1) is coated with an oxidation and/or corrosion resistant coating comprising Al and/or Cr,
**characterised in** that the article comprises:
- a first external surface section (5, 11) with a first Al and/or Cr containing coating applied by means of chemical vapour deposition, and
- a second external surface section (15) with a second Al and/or Cr containing coating applied by means of a spray process.

## Description

The present invention relates to a coated article. In addition, the invention relates to method of applying an oxidation and/or corrosion resistant coating comprising Al and Cr to an article.

Articles that are subject to high loads in hot and corrosive environments, for example turbine blades, are often made from high temperature resistant superalloys. In addition, such articles are typically coated with oxidation and/or corrosion resistant coatings to prolong their service lifetime. For example, turbine blades may be coated with MCrAlY-coatings where M stands for iron (Fe), cobalt (Co) or nickel (Ni), and Y stands for yttrium (Y) and/or silicon (Si) and/or hafnium (Hf) and/or at least one rare earth element other than yttrium. Such MCrAlY-coatings are typically applied by means of formal spray processes. Other known coatings used to increase oxidation and/or corrosion resistance are aluminide coatings and chrome aluminide coatings which can be applied to a turbine blade by means of pack cementation or chemical vapour deposition processes. Which kind of coating is used for a turbine blade is typically decided depending on the substrate composition and the environment the turbine blade is to be used.

It is an objective of the present invention to provide an advantageous article for use in a hot and corrosive medium where at least a section of the external surface of the article is coated with an oxidation and/or corrosion resistant coating. It is a further objective of the present invention to provide an advantageous method for coating an article to be used in a hot and corrosive medium.

The first objective is achieved by an article as claimed in claim 1, and the second objective is achieved by a method as claimed in claim 7. The depending claims contain further developments of the invention.

An inventive article for use in a hot and corrosive medium has at least a section of an external surface coated with an oxidation and/or corrosion resistant coating comprising aluminium (Al) and/or chromium (Cr). According to the invention, the article comprises a first external surface section with a first Al and/or Cr containing coating applied by means of chemical vapour deposition, and a second external surface section with a second Al and/or Cr containing coating applied by means of a spray process. In particular, the first Al and/or Cr containing coating may be an aluminide coating or a chrome aluminide coating and the second Al and/or Cr containing coating may be a MCrAlY-coating, where M stands for a metal selected from the group consisting of Fe, Co, Ni or combinations thereof, Cr stands for chrome, Al stands for aluminium, and Y stands for at least one element selected from the group consisting of Si, Hf, Y and the other rare earth elements.

According to the invention, different sections of the article surface to be coated are coated by means of different coating processes. Using different processes is advantageous if an article having a complex geometry is to be coated. For example, turbine blades have an airfoil section with an airfoil surface, a blade root and a platform being located between the airfoil section and the blade root. The platform has a platform surface showing towards the airfoil section and a platform section that extents between the platform surface and the blade root. In some turbine blades this platform section has a complex geometry with pocket-like structures and recesses in its side faces. If, for example, such a turbine blade is to be coated by means of a spray process coating the surfaces inside the recesses the pockets is difficult because of recirculation processes taking place within the recesses and pockets.

By using a spray process only for coating the airfoil surface and the platform surface that shows towards the airfoil section and using a chemical vapour deposition process for the other surface sections to be coated the surfaces inside the recesses and at the pockets can easily be coated so that overall an improved coating can be achieved.

Moreover, in the given example only the airfoil surface and the platform surface that shows towards the airfoil section are exposed to the hot and corrosive medium when the turbine blade is used in a gas turbine. Hence it is sufficient if only these surfaces are coated with an MCrAlY-coating. The other surface sections can then be coated with an aluminide coating or a chrome aluminide coating which can easily applied by use of a chemical vapour deposition process. Using a chemical vapour deposition process allows for evenly coating the platform section including the surfaces inside the recess and the pockets. Hence, according to a special development of the present invention the article is a turbine blade with an airfoil section having an airfoil surface, a blade root, and a platform being located between the airfoil section and the blade root. The platform has a platform surface which shows towards the airfoil section and a platform section which extends between the platform surface and the blade root. In this turbine blade, the first external surface section, which is coated by means of the chemical vapour deposition process, includes at least a part of the blade root and the surface of the platform section that extents between the platform surface and the blade root. Note that the recesses and pockets of the platform are typically present in this platform section. The second external surface section, which is coated by means of the spray process, is given by the airfoil surface and the platform surface.

In a turbine blade, the blade root comprises end faces and side faces extending between the end faces. According to a further development of the invention, the end faces are coated by means of the chemical vapour deposition process while the side faces are not coated. Not coating the side faces is advantageous since the side faces are typically manufactured with precise final dimensions which shall not be altered in subsequent process steps. In addition, the side faces come into contact with the walls of notches of rotor disks to which the rotor blade will be installed for use in a rotor of a gas turbine. As the dimensions of the notches are slightly larger than the dimensions of the blade root so as to allow a slight movement of the rotor blades contact between the side faces and the notch wall could lead to aberration of coating material which could then act as an abrasive between the notch wall and the side face and, thereby, reduce service lifetime of the turbine blade.

Moreover, in the turbine blade, the airfoil section may comprise a blade tip with a recess having a recess surface. In this case, the first external surface section may include the recess surface. What has been said with respect to the surfaces within recesses and pockets of the platform also applies to the recess surface of the blade tip.

If the turbine blade comprises an internal surface it is advantageous if this internal surface is also coated with first coating. Since internal surfaces to be coated are often present in turbine blades and these surfaces are typically coated by use of chemical vapour deposition processes the coating of the first external surface section can be done without loss of time when it is done together with the coating the internal surfaces.

According to the invention, also a method of applying an oxidation and/or corrosion resistant coating comprising Al and/or Cr to at least a section of an external surface of an article that is to be used in a hot and corrosive medium is provided. In the method, a first external surface section is coated by means of a chemical vapour deposition process and a second external surface section is coated by means of a spray process. In particular, an aluminide coating or a chrome aluminide coating may be applied by the chemical vapour deposition process, and an MCrAlY-coating may be applied by the spray process.

The inventive method allows for producing an inventive article and, hence, for realising the advantages mentioned with respect to the inventive article.

The inventive method may, in particular, be applied when coating a turbine blade with an airfoil section having an airfoil surface, a blade root and a platform being located between the airfoil section and the blade root, where the platform has a platform surface which shows towards the airfoil section and a platform section which extends between the platform surface and the blade root. In this case, the first external surface section, which is coated by means of the chemical vapour deposition process, includes at least a part of the blade root and the platform surface. The second external surface section, which is coated by means of the spray process, is given by the airfoil surface and the platform surface. The blade root may comprise end faces which are coated by means of the chemical vapour deposition process and side faces which extend between the end faces and which are not coated. The advantage of not coating the side faces has been described above with respect to the inventive article and will, therefore, not be described again.

The airfoil section may comprise a blade tip with a recess having a recess surface. In this case, the recess surface may be coated by a means of the chemical vapour deposition process. In other words, the recess surface may be part of the first external surface section. Again, the advantage of the recess surface being part of the first external surface section has already been described above with respect to the inventive article and will, therefore, not be repeated.

If the article to be coated also includes one or more internal surfaces to be coated it is advantages if the chemical vapour deposition process is also used for coating the internal surface of the article. By this measure the first external surface section and the internal surface can be coated simultaneously. Since internal surfaces are often coated by use of a chemical vapour deposition process a simultaneous coating may be easily realised.

Further features, properties and advantages of the present invention will become clear from the following description of embodiments in conjunction with the accompanying drawings.
Figure 1 shows, as an example for an inventive article a turbine blade for use in a gas turbine rotor in a perspective view.
Figure 2 shows a detail of figure 1.
Figure 3 shows internal sections of the turbine blade shown in figure 1.
Figure 4 shows a step of the inventive method of applying an oxidation and/or corrosion resistant coating.
Figure 5 shows a further step of the inventive method of applying an oxidation and/or corrosion resistant coating.
Figure 6 shows an example of a gas turbine engine in a sectional view.

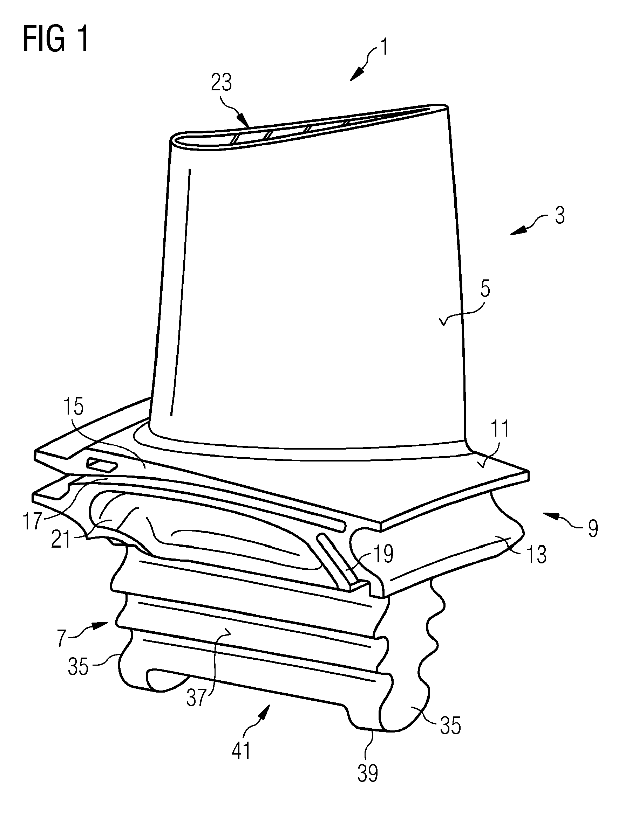

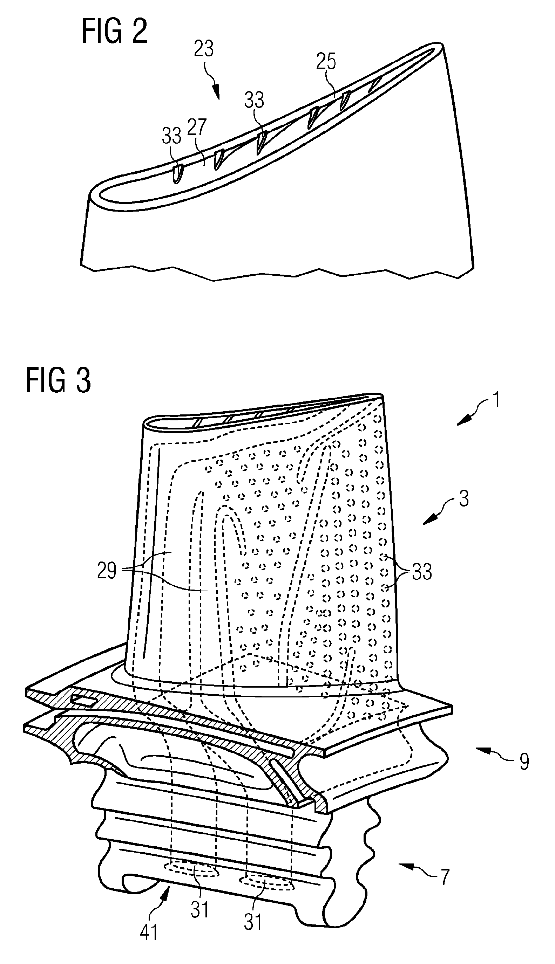

As an example for an inventive article for use in a hot and corrosive medium, were at least a section of an external surface of the article is coated with an oxidation and/or corrosion resistant coating comprising Al and/or Cr, figures 1 to 3 show a gas turbine blade for use in rotor disks of gas turbine rotors. In these figures, figure 1 shows the turbine blade in a perspective view and figure 2 shows the tip of the blade in more detail. Figure 3 shows in internal cooling passages of the turbine blade.

The turbine blade 1 of the present embodiment comprises an airfoil section 3 with an airfoil surface 5, a blade root 7 which has a fir tree shape, and a platform 9 that is located between the airfoil section 3 and the blade root 7. The platform 9 has a platform surface 11 which shows towards the airfoil 3 and which forms a wall part of a flow path along which a hot and corrosive working medium of a gas turbine flows when the gas turbine is in operative. The platform 9 further comprises a platform section 13 that extends between the platform surface 11 and the blade root 7.

The platform section 13 has side faces 15 which show towards side faces of neighbouring turbine blades when the turbine blade is installed to a rotor disk of a gas turbine engine. When the turbine blades are installed to a rotor disk seal strips (not shown in the figure) are placed between the opposing sides faces 15 of neighbouring turbine blades. These seal strips are introduced into notches 17, 19 formed in the side faces 15 of the platforms 9. Moreover, pockets 21 are present in the platform section 13 in order to reduce weight of the turbine blade 1 and to allow cooling air to reach larger sections of the platform 9.

The blade 1 has a blade tip 23 which forms the radial other end of the blade when it is installed to a rotor disk. The blade tip 23, which is shown in more detail in figure 2, comprises a rim 25 and a recess 27 that is surrounded by the rim 25. The rim may serve as a so called squealer tip. Such squealer tips are often coated with an abrasive material that rubs into a seal ring of the outer wall of the flow path of a gas turbine during start-up operation of the engine so that only a minimal necessary gap is formed between the blade tip and the outer wall of the flow path.

As shown in figure 3, the turbine blade 1 is equipped with internal cooling passages 29 which are fed with cooling air through openings 31 in the blade root 7. After passing through the internal cooling passages 29 the cooling air is blown out of the airfoil 3 by means of film cooling holes 33 so as to form a cooling air film over the airfoil surface 5.

As the turbine blade 1 is to be used in a hot and corrosive working medium of a gas turbine it is made a high temperature resistant superalloy such as a nickel based superalloy, a cobalt based superalloy or an iron based superalloy. In addition it is coated with oxidation and/or corrosion resistant coatings in order to prolong its lifetime in the hot and corrosive environment. Oxidation and/or corrosion resistance is thereby substantially achieved through aluminium and chromium present in the coating.

The turbine blade 1 shown in figures 1 to 3 is coated with two different coating systems, namely a chrome aluminide coating and an MCrAlY-coating. The MCrAlY-coating is present on the airfoil surface 5 and the platform surface 11. In addition, the MCrAlY-coating is also present on the surface of the rim 25 of the blade tip 23 in the present embodiment. The chrome aluminide coating is present on all other surfaces of the platform 9. In particular, the chrome aluminide coating is present on the side faces 15 of the platform 9, including the faces of the notches 17, 19 and the faces of the pockets 21. In addition, the chrome aluminide coating is also present on end faces 35 of the blade root 7. The chrome aluminide coating may also be present on the surface of the recess 27 in the blade tip 23.

No coating is present on the side faces 37 and the bottom face 39 of the blade root 7. If the blade root 7 comprises an open space 41 in the bottom face 39 of the blade root 7, as it is shown in figures 1 and 3, the inside walls of this opening, which extends to the entrance openings 31 of the internal cooling passages, is typically also uncoated.

Like the external surface sections of the turbine blade 1 also the internal surface of the blade, i.e. the surface of the internal cooling passages 29, is coated. In the present embodiment, the internal surface is also coated with a chrome aluminide coating.

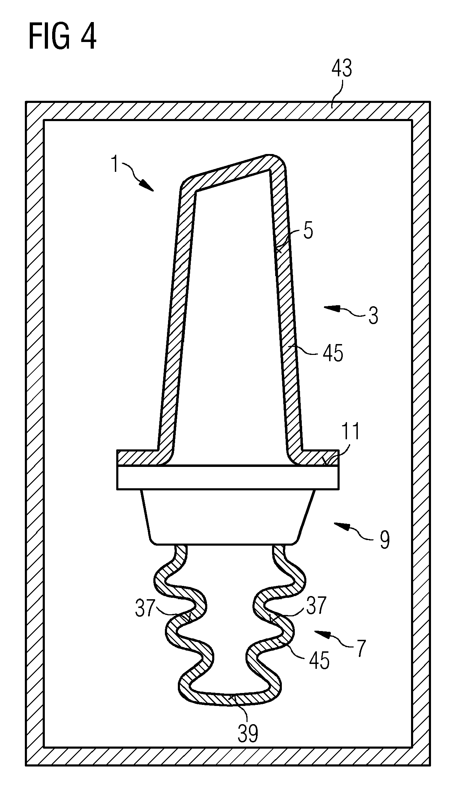

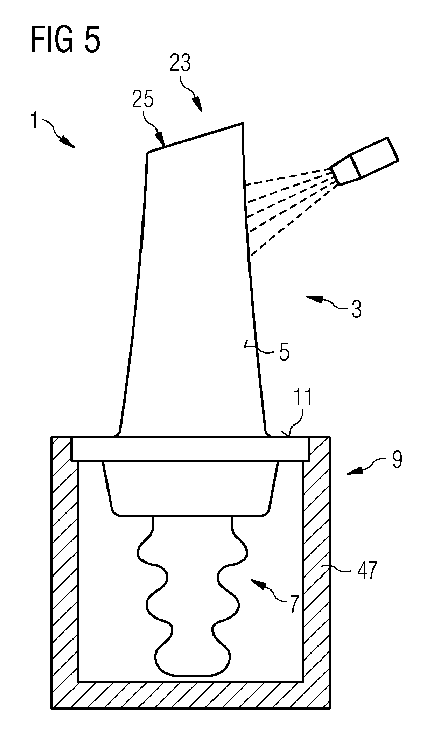

A method of applying the coating system which has been described with respect to figures 1 to 3 will now be described with respect to figures 4 and 5.

For applying the chrome aluminide coating the airfoil surface 5, the platform surface 11, the side faces 37 of the blade root 7, and the bottom face 39 of the blade root are masked by a suitable maskant. Then the blade 1 is put into a chamber into which chrome vapour and aluminium vapour is introduced during a chemical vapour deposition process. During the chemical vapour deposition process, chromium from the chrome vapour and the aluminium from the aluminium vapour is deposited on free surfaces of the turbine blade so as to form a chrome aluminide coating. In order to have the same amount of chromium and aluminium deposited on the free surfaces of the turbine blade the temperature in the chamber is controlled to be in a temperature range between 1,000°C and 1,150 °C. The chemical vapour deposition process takes about 3 to 4 hours. In order to withstand such high temperatures over 3 to 4 hours the masking material may be based on a ceramic powder like, for example, alumina powder or zirconia powder, as it is described in EP 1 352 988 A1 and EP 1 508 628 A1, or based on a carbon precursor, as it is described in EP 1 681 366 A1. Note that for producing a turbine blade as shown in figures 1 to 3 the masking material would leave open the entrance openings 31 of the internal cooling passages 29 and the recess 27 in the blade tip 23 so that the chrome aluminide layer can also be deposited onto the internal surfaces of the turbine blade 1 and the surface of the recess 27.

After the chemical vapour deposition process has been finished the masking material is removed from the turbine blade 1.

In a next step, the turbine blade 1 is masked again, as shown in figure 5. This time, the masking is such that only the airfoil surface 5, the platform surface 11 and the surface of the rim 25 of the blade tip 23 remain unmasked. Note that the cooling holds in the airfoil (not shown in figure 5) as well as the recess 27 in the blade tip 23 are filled with a filling material. The filling material may be a polymer material or a material as it is used for masking the turbine blade during the chemical vapour deposition process.

In the present embodiment, the blade root 7 and all sections of the platform 9 except for its platform surface 11 are masked by putting the turbine blade into a masking box which surrounds the blade root 7 and the platform 9 except for the platform surface 11. Then, the remaining free surfaces, i.e. the airfoil surface 5, the platform surface 11 and the surface of the rim 25 are coated by means of a spray process. As spray process, a number of thermal spray processes may be used, including plasma spraying, high velocity oxygen fuelled spraying, cold gas spraying, laser spraying, flame spraying, detonation spraying and arc spraying.

After the spray process has been finished the masking box 47 is removed and the cooling channels as well as the recess 27 in the blade tip 23 are reopened by removing the filling material. In case of the cooling holes it may be necessary to reopen them by use of a suitable drilling process.

A thermal barrier coating, for example a zirconium oxide coating that is at least partially stabilized by yttrium (YSZ-coating), may be applied onto the MCrAlY-coating. In this case, the turbine blade remains masked after the MCrAlY-coating has been applied, and the thermal barrier coating is applied onto the MCrAlY-coating, e.g. by use of further spray process, before the masking is removed.

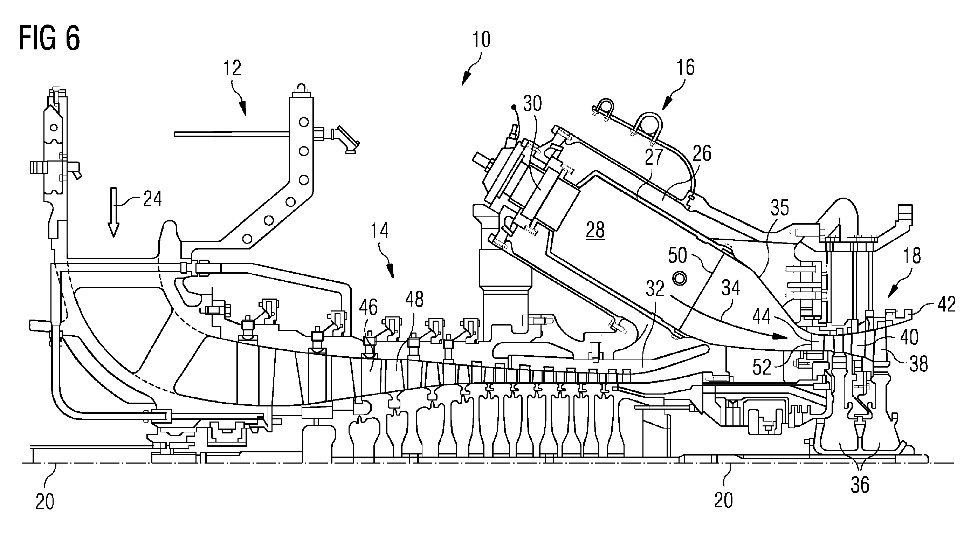

As has been mentioned above, a number of rotor blades as described with respect to figures 1 to 3 will be inserted into notches of a rotor disk of a gas turbine rotor. In the following, such a gas turbine will be shortly described with respect to figure 6.

In the following description, the terms upstream and downstream refer to the flow direction of the airflow and/or working gas flow through the engine unless otherwise stated. The terms forward and rearward refer to the general flow of gas through the engine. The terms axial, radial and circumferential are made with reference to a rotational axis 20 of the engine.

FIG. 6 shows an example of a gas turbine engine 10 in a sectional view. The gas turbine engine 10 comprises, in flow series, an inlet 12, a compressor section 14, a combustor section 16 and a turbine section 18 which are generally arranged in flow series and generally in the direction of a longitudinal or rotational axis 20. The gas turbine engine 10 further comprises a shaft 22 which is rotatable about the rotational axis 20 and which extends longitudinally through the gas turbine engine 10. The shaft 22 drivingly connects the turbine section 18 to the compressor section 12.

In operation of the gas turbine engine 10, air 24, which is taken in through the air inlet 12 is compressed by the compressor section 12 and delivered to the combustion section or burner section 16. The burner section 16 comprises a burner plenum 26, one or more combustion chambers 28 defined by a double wall can 49 and at least one burner 30 fixed to each combustion chamber 28. The combustion chambers 28 and the burners 30 are located inside the burner plenum 26. The compressed air passing through the compressor 12 enters a diffuser 32 and is discharged from the diffuser 32 into the burner plenum 26 from where a portion of the air enters the burner 30 and is mixed with a gaseous or liquid fuel. The air/fuel mixture is then burned and the combustion gas 34 or working gas from the combustion is channeled via a transition duct 51 to the turbine section 18.

The turbine section 18 comprises a number of blade carrying discs 36 attached to the shaft 22. In the present example, two discs 36 each carry an annular array of turbine blades 38. However, the number of blade carrying discs could be different, i.e. only one disc or more than two discs. In addition, guiding vanes 40, which are fixed to a stator 42 of the gas turbine engine 10, are disposed between the turbine blades 38. Between the exit of the combustion chamber 28 and the leading turbine blades 38 inlet guiding vanes 44 are provided.

The combustion gas from the combustion chamber 28 enters the turbine section 18 and drives the turbine blades 38 which in turn rotates the shaft 22. The guiding vanes 40, 44 serve to optimise the angle of the combustion or working gas on to the turbine blades 38. The compressor section 12 comprises an axial series of guide vane stages 46 and rotor blade stages 48.

The turbine blades of at least one blade carrying dics 36 in this gas turbine are turbine blades as described with respect to Figures 1 to 3.

The present invention has been described with respect to a gas turbine blade as an exemplary embodiment for an inventive article. However, the present invention can also be practiced with other articles that are to be used in a hot and corrosive environment. Moreover, not all details that have been described with respect to the specific embodiment are mandatory. For example, the blade tip does not need to have a recess and a rim. Likewise, the shape of the blade root or the platform may differ from what is depicted throughout the figures.

Furthermore, the coating applied by means of chemical vapour deposition may be an aluminide coating without Cr. In addition, also departures from the method steps described with respect to figures 4 and 5 are possible. For example, a masking box 47 has been described for masking the blade in the spray process. However, the same kind of maskant as used for the chemical vapour deposition process could also be used for masking the blade 1 during the spray process. Hence, the present invention shall not be restricted to the specific embodiments which have been described with respect to the figures. Instead, the scope of protection shall only be restricted by the appended claims.

## Claims

1. An article (1) for use in a hot and corrosive medium, where at least a section of an external surface of the article (1) is coated with an oxidation and/or corrosion resistant coating comprising Al and/or Cr,
**characterised in that** the article comprises:
- a first external surface section (15) with a first Al and/or Cr containing coating applied by means of chemical vapour deposition, and
- a second external surface section (5, 11) with a second Al and/or Cr containing coating applied by means of a spray process.

2. The article (1) as claimed in claim 1, **characterised in that** the first Al and/or Cr containing coating is an aluminide coating or a chrome aluminide coating and the second Al and/or Cr containing coating is an MCrAlY-coating.

3. The article (1) as claimed in claim 1 or claim 2, **characterised in that**
- the article (1) is a turbine blade with an airfoil (3) having an airfoil surface (5), a blade root (7) and a platform (9), where the platform (9) is located between the airfoil (3) and the blade root (7) and has a platform surface (11) showing towards the airfoil (9) and a platform section (13) extending between the platform surface (11) and the blade root (9),
- the first external surface section includes at least a part of the surface of the blade root (35) and the surface of the platform section (13) that extends between the platform surface (11) and the blade root (7), and
- the second external surface section is given by the airfoil surface (5) and the platform surface (11).

4. The article (1) as claimed in claim 3, in which the blade root (7) comprises end faces (35) and side faces (37) extending between the end faces (35), where the end faces (35) are coated by a means of the chemical vapour deposition process while the side faces (37) are not coated.

5. The article (1) as claimed in claim 3 or claim 4, **characterised in that** the airfoil (3) comprises a blade tip (23) with a recess (27) having a recess surface, where the first external surface section includes the recess surface.

6. The article (1) as claimed in any of the claims 1 to 5, **characterised in that** it comprises an internal surface that is coated with the first coating.

7. A method of applying an oxidation and/or corrosion resistant coating comprising Al and/or Cr to at least a section of an external surface of an article (1) that is to be used in a hot and corrosive medium,
**characterised in**
- coating a first external surface section (15) by means of chemical vapour deposition, and
- coating a second external surface section (5,11) by a means of a spray process.

8. The method as claimed in claim 7, **characterised in that** a chrome aluminide coating or an aluminide coating is applied by the chemical vapour deposition process and an MCrAlY-coating is applied by the spray process.

9. The method as claimed in claim 7 or claim 8, **characterised in that**
- the article (1) is a turbine blade with an airfoil (3) having an airfoil surface (5), a blade root (7) and a platform (9), where the platform (9) is located between the airfoil (3) and the blade root (7) and has a platform surface (11) showing towards the airfoil (3) and a platform section (13) extending between the platform surface (11) and the blade root (7),
- the first external surface section includes at least a part of the surface of the blade root (35) and the surface of the platform section (13) that extends between the platform surface ()11 and the blade root (7), and
- the second external surface section is given by the airfoil surface (5) and the platform surface (11).

10. The method as claimed in claim 9, in which the blade root (7) comprises end faces (35) and side faces (37) extending between the end faces (35), where the end faces (35) are coated by a means of the chemical vapour deposition process while the side faces (37) are not coated.

11. The method as claimed in claim 9 or claim 10, **characterised in that** the airfoil (3) comprises a blade tip (23) with a recess (27) having a recess surface, where the recess surface is coated by means of the chemical vapour deposition process.

12. The method as claimed in any of the claims 7 to 11, **characterised in that** the chemical vapour deposition process is also used for coating an internal surface of the article.
